# EUROPEAN PATENT APPLICATION

(11) **EP 3 763 853 A1**
(43) Date of publication of application: **13.01.2021**
(21) Application number: 19764126.9
(22) Date of filing: 14.02.2019
(51) Int. Cl.: C30B 29/36, C23C 14/06, C30B 23/02

(54) **PRODUCTION METHOD FOR SILICON CARBIDE SINGLE CRYSTAL**

(30) Priority: 08.03.2018 JP 2018042289
(71) Applicant: Shin-Etsu Handotai Co., Ltd., Tokyo 100-0004 (JP)
(72) Inventor: IKEDA Hitoshi, Annaka-shi, Gunma 379-0196 (JP); MATSUMOTO Yuichi, Annaka-shi, Gunma 379-0196 (JP); TAKAHASHI Toru, Annaka-shi, Gunma 379-0196 (JP)
(74) Representative: Wibbelmann, Jobst
(86) International application number: PCT/JP2019/005388
(87) International publication number: WO 2019/171901

(57) **Abstract**

The present invention provides a method for manufacturing a silicon carbide single crystal by sublimating a solid silicon carbide raw material in a growth container to grow a silicon carbide single crystal on a seed crystal substrate. The method includes: mixing a tantalum (Ta) powder with a carbon powder; attaching the mixture to the solid silicon carbide raw material in the growth container; and heating the resultant for sintering to form a tantalum carbide (TaC) coating film on a surface of the solid silicon carbide raw material. A silicon carbide single crystal is grown after or while the coating film is formed. Thereby, the present invention provides a method for manufacturing a silicon carbide single crystal with few carbon inclusions.

## Description

### TECHNICAL FIELD

The present invention relates to a method for manufacturing silicon carbide in which a silicon carbide crystal is grown by a sublimation method.

### BACKGROUND ART

Recently, inverter circuits have been commonly used in electric vehicles and electric air-conditioners. This creates demands for semiconductor crystal of silicon carbide (hereinafter may also be referred to as SiC) because of the properties of less power loss and higher breakdown voltage in devices than those using semiconductor Si crystal.

As a typical and practical method for growing a crystal with a high melting point or a crystal that is difficult to grow by liquid phase growth such as SiC, a sublimation method exists. In this method, a solid raw material is sublimated in a container at a high temperature around 2000°C or higher, and a crystal is grown on a seed crystal located on the opposite side (Patent Document 1).

However, SiC crystal growth requires high temperature for the sublimation, and the growth apparatus requires temperature control at the high temperature. Moreover, to stabilize the pressure of the sublimated substance, it is necessary to steadily control the pressure inside the container. Further, SiC crystal growth depends on the sublimation rate, and the growth rate is relatively quite slow in comparison with Czochralski method for Si, LPE manufacturing method for GaAs and so forth, for example. Hence, long time is required for the growth. Fortunately, the developments of control units, computers, personal computers, and so forth nowadays enable long-term steady adjustments of pressure and temperature.

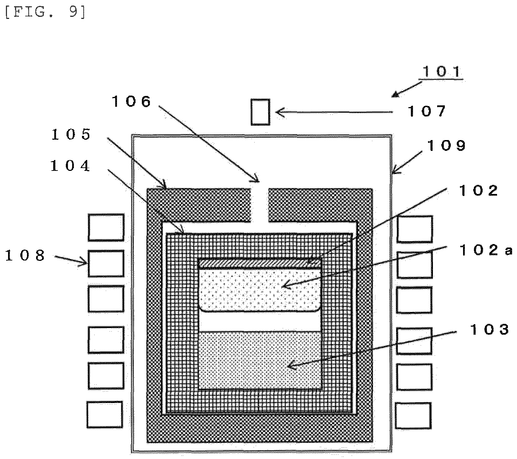

FIG. 9 shows a schematic cross-sectional view of a SiC manufacturing apparatus. Specifically, a method for growing SiC by sublimation is performed using a SiC manufacturing apparatus 101 as shown in FIG. 9. A solid silicon carbide raw material 103 is put in a growth container 104, and heated with a heater (radio-frequency heating coil) 108. Thus, a crystal is grown on a seed substrate (seed wafer) 102 disposed in the growth container 104.

The growth container 104 is disposed in a vacuum quartz tube or a vacuum chamber, and filled with a gas with low reactivity once. The atmosphere is lower than the atmospheric pressure so as to increase the SiC sublimation rate.

Outside the growth container 104, a heat-insulating material (heat-insulating container) 105 is disposed. At least one hole (upper-portion temperature measurement hole) 106 for measuring the temperature with a pyrometer is provided to a portion of the heat-insulating material 105. Hence, some heat escapes through the hole.

The growth container 104 is mainly made of a carbon material and is air permeable, and the pressures inside and outside the container are equal. Nevertheless, when the sublimation starts, the sublimated gas leaks outside the container.

In practice, the solid silicon carbide raw material 103 is disposed at a lower portion of the growth container 104. The material 103 is solid, and sublimates at high temperature under reduced pressure. The sublimated material grows as a single crystal on the seed crystal 102 located on the opposite side. In the case of SiC, the single crystal includes cubic, hexagonal crystals, for example. Further, among hexagonal crystals, 4H, 6H, and so forth are known as typical polytypes.

In many cases, single crystal grows on the same type like 4H grows on a 4H type (Patent Document 2).

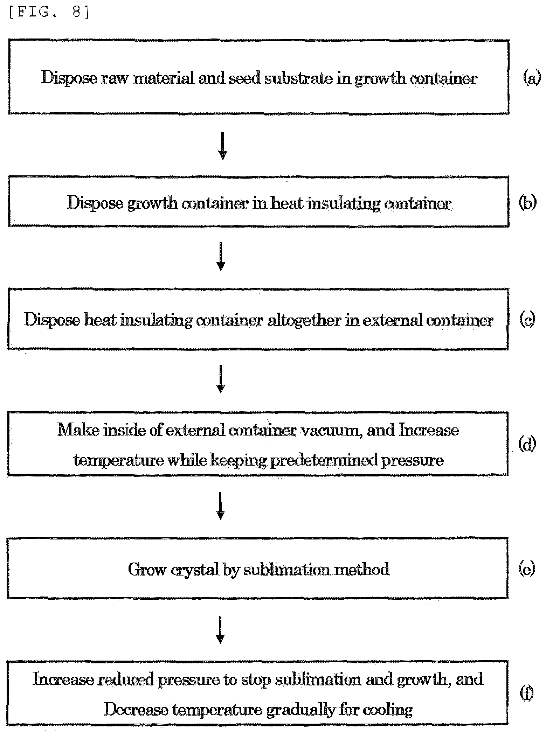

Here, a conventional method for manufacturing a silicon carbide single crystal will be described using a flowchart in FIG. 8.

As described in FIG. 8(a), the solid silicon carbide raw material 103 and the seed substrate (seed wafer) 102 are disposed in the growth container 104. Next, as described in FIG. 8(b), the growth container 104 is disposed in the heat-insulating container 105. Next, as described in FIG. 8(c), the heat-insulating container 105 as a whole is disposed in an external container (made of SUS, quartz, or the like) 109. Next, as described in FIG. 8(d), the inside of the external container 109 is made vacuum, and the temperature is raised while a predetermined pressure is being kept. Next, as described in FIG. 8(e), a SiC single crystal is grown by sublimation method. Finally, as described in FIG. 8(f), the reduced pressure is increased to stop the sublimation and the growth, and the temperature is gradually lowered for cooling.

### CITATION LIST

### PATENT LITERATURE

Patent Document 1: Japanese Unexamined Patent Application Publication No. 2000-191399
Patent Document 2: Japanese Unexamined Patent Application Publication No. 2005-239465

### SUMMARY OF INVENTION

### TECHNICAL PROBLEM

However, in the above-described conventional method for manufacturing a silicon carbide single crystal, carbon is incorporated as inclusions in a single crystal during the growth of the silicon carbide single crystal. When the carbon as a mass is exposed from the wafer surface in the wafer processing, the carbon mass is removed, so that a pit is left where a polishing agent and a cleaning agent accumulate. Substances generated therefrom cause contamination and scratch on the wafer surface, bringing about a problem. Such carbon inclusions can be observed by inspecting the wafer with a transmission microscope.

The present invention has been made in view of the above-described problems. An object of the present invention is to provide a method for manufacturing a silicon carbide single crystal with few carbon inclusions.

### SOLUTION TO PROBLEM

To achieve the object, the present invention provides a method for manufacturing a silicon carbide single crystal by sublimating a solid silicon carbide raw material in a growth container to grow a silicon carbide single crystal on a seed crystal substrate, the method comprising:
mixing a tantalum (Ta) powder with a carbon powder;
attaching the mixture to the solid silicon carbide raw material in the growth container; and
heating the resultant for sintering to form a tantalum carbide (TaC) coating film on a surface of the solid silicon carbide raw material, wherein
a silicon carbide single crystal is grown after or while the coating film is formed.

In this way, a silicon carbide single crystal is grown after or while a tantalum carbide (TaC) coating film is formed on the surface of the solid silicon carbide raw material. This makes it possible to prevent carbon mass from floating from the solid raw material, thereby manufacturing a silicon carbide single crystal with few carbon inclusions.

Moreover, when the growth container is made of carbon, a mixture of a tantalum (Ta) powder and a carbon powder is preferably further attached to an inner wall of the growth container.

### Such

When the growth container is made of carbon, attaching a mixture of a tantalum (Ta) powder with a carbon powder also to the inner wall of the growth container as described above makes it possible to prevent reaction between the raw-material gas and the carbon of the growth container, and consequently inclusion of the carbon into the single crystal during the growth.

### ADVANTAGEOUS EFFECTS OF INVENTION

As described above, the inventive method for manufacturing a silicon carbide single crystal makes it possible to prevent carbon mass from floating from the solid raw material. This enables production of a silicon carbide single crystal with few carbon inclusions.

### BRIEF DESCRIPTION OF DRAWINGS

FIG. 1 is a flowchart showing a method for manufacturing a silicon carbide single crystal according to a first embodiment of the present invention.
FIG. 2 is a schematic cross-sectional view of a SiC manufacturing apparatus with which the method for manufacturing a silicon carbide single crystal according to the first embodiment of the present invention can be carried out.
FIG. 3 is a flowchart showing a method for manufacturing a silicon carbide single crystal according to a second embodiment of the present invention.
FIG. 4 is a schematic cross-sectional view of a SiC manufacturing apparatus with which the method for manufacturing a silicon carbide single crystal according to the second embodiment of the present invention can be carried out.
FIG. 5 shows the distribution and average number (density) of carbon inclusions in a wafer plane of Example 1.
FIG. 6 shows the distribution and average number (density) of carbon inclusions in a wafer plane of Example 2.
FIG. 7 shows the distribution and average number (density) of carbon inclusions in a wafer plane of Comparative Example.
FIG. 8 is a flowchart showing a conventional method for manufacturing a silicon carbide single crystal.
FIG. 9 is a schematic cross-sectional view of a typical apparatus for manufacturing a silicon carbide single crystal.

### DESCRIPTION OF EMBODIMENTS

Hereinafter, the present invention will be described in detail with reference to the drawings as an example of embodiments. However, the present invention is not limited thereto.

### (First Embodiment)

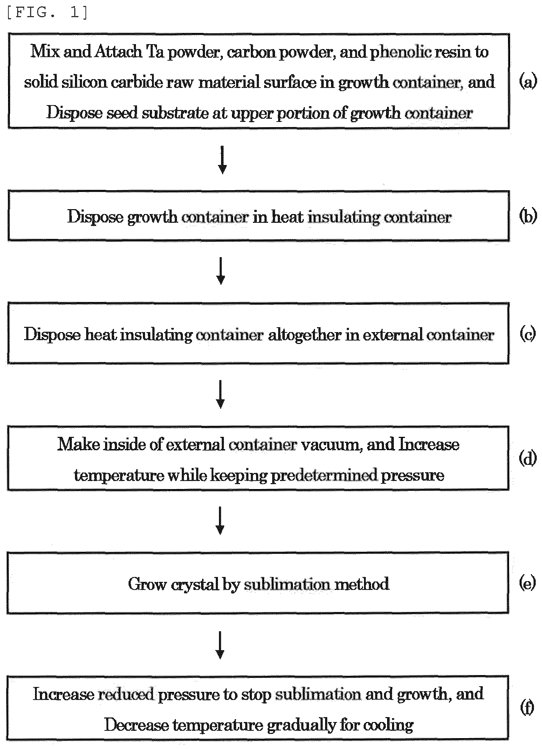

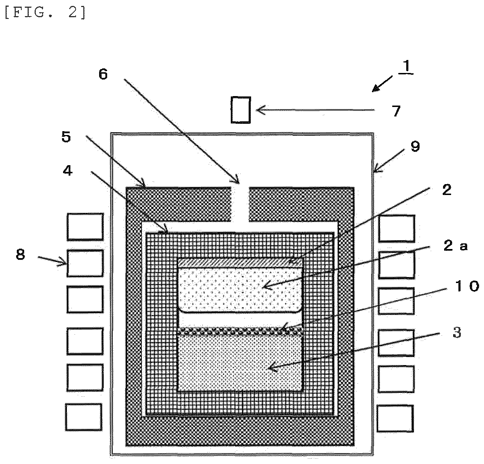

Herein below, a method for manufacturing a silicon carbide single crystal according to a first embodiment of the present invention will be described with reference to FIGs. 1, 2.

FIG. 1 is a flowchart showing the method for manufacturing a silicon carbide single crystal according to the first embodiment of the present invention. FIG. 2 is a schematic cross-sectional view of a SiC manufacturing apparatus with which the method for manufacturing a silicon carbide single crystal according to the first embodiment of the present invention can be carried out.

As shown in FIG. 2, a SiC manufacturing apparatus 1 includes a growth container 4 for housing a seed substrate (seed wafer) 2 and a solid silicon carbide raw material 3, a heat-insulating container 5 surrounding the growth container 4, a temperature-measurement sensor 7 for measuring the temperature inside the growth container 4 via an upper-portion temperature measurement hole 6 provided through the heat-insulating container 5, a heater (radio-frequency heating coil) 8 for heating the solid silicon carbide raw material 3, and an external container 9 for housing the heat-insulating container 5.

In the method for manufacturing a silicon carbide single crystal according to the first embodiment of the present invention, first, as described in FIG. 1(a), a Ta powder, a carbon powder, and a phenolic resin are mixed together, and attached to a surface of the solid silicon carbide raw material 3 in the growth container 4. Then, the seed substrate (seed wafer) 2 is disposed at an upper portion in the growth container 4. Mixing with the phenol resin facilitates uniform attachment of the Ta powder and the carbon powder to the solid raw material surface.

Note that the solid silicon carbide raw material 3 is obtained by melting a SiC powder and cooling it into a block form.

Next, as described in FIG. 1(b), the growth container 4 is disposed in the heat-insulating container 5.

Next, as described in FIG. 1(c), the heat-insulating container 5 as a whole is disposed in the external container 9. The external container 9 is made of, for example, SUS, quartz, or the like.

Next, as described in FIG. 1(d), the inside of the external container 9 is made vacuum, and the temperature is raised while a predetermined pressure is being kept. Here, the inside of the external container 9 may be an argon atmosphere, nitrogen atmosphere, or the like. Preferably, in this event, the temperature is 2000°C or more, and the pressure is 100 Torr (133 hPa) or less.

Next, as described in FIG. 1(e), a SiC single crystal (grown crystal) 2a is grown by a sublimation method. In this event, what adheres on the surface of the solid silicon carbide raw material 3 is sintered, and a tantalum carbide (TaC) coating film 10 is formed on the surface of the solid silicon carbide raw material 3 (see FIG. 2).

Finally, as described in FIG. 1(f), the reduced pressure is increased to stop the sublimation and the growth, and the temperature is gradually lowered for cooling.

According to the manufacturing method as described above, a silicon carbide single crystal is grown while the tantalum carbide (TaC) coating film 10 is being formed on the surface of the solid silicon carbide raw material 3. This makes it possible to prevent a carbon mass from floating from the solid raw material, thus reducing carbon inclusion in the grown silicon carbide crystal.

### (Second Embodiment)

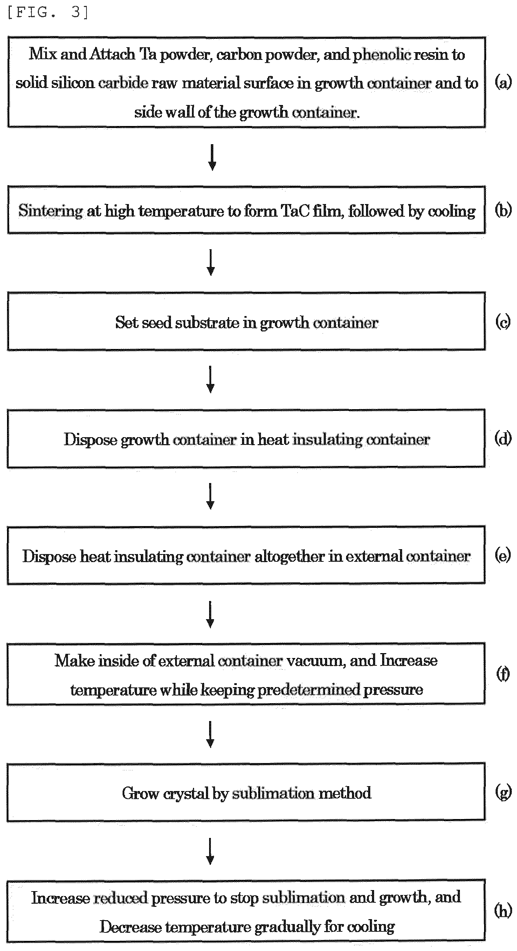

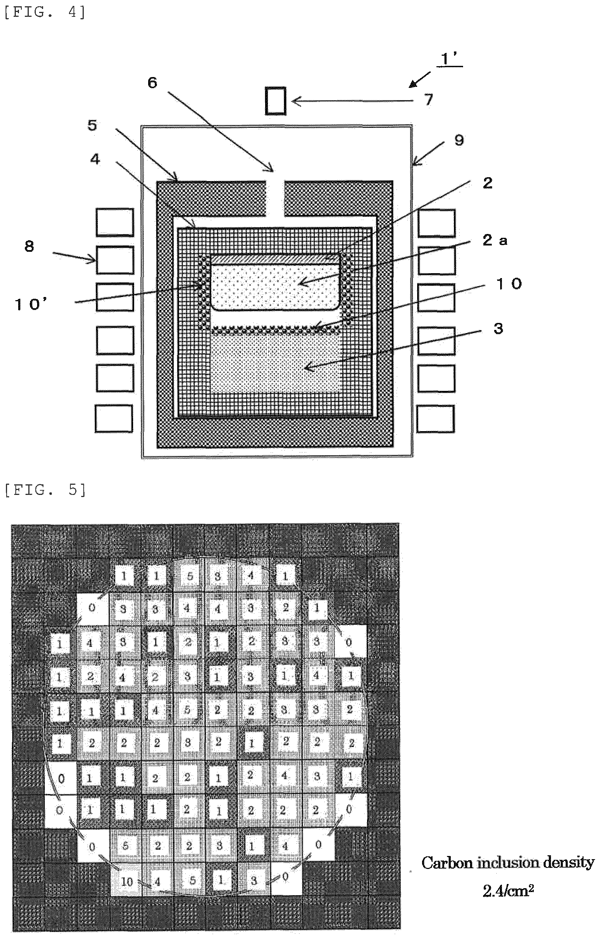

Next, a method for manufacturing a silicon carbide single crystal according to a second embodiment of the present invention will be described with reference to FIGs. 3, 4.

FIG. 3 is a flowchart showing the method for manufacturing a silicon carbide single crystal according to the second embodiment of the present invention. FIG. 4 is a schematic cross-sectional view of a SiC manufacturing apparatus with which the method for manufacturing a silicon carbide single crystal according to the second embodiment of the present invention can be carried out. A SiC manufacturing apparatus 1' in FIG. 4 has the same configuration as that of the SiC manufacturing apparatus 1 in FIG. 2.

In the method for manufacturing a silicon carbide single crystal according to the second embodiment of the present invention, first, as described in FIG. 3(a), a Ta powder, a carbon powder, and a phenolic resin are mixed together, and attached to the surface of the solid silicon carbide raw material 3 in the growth container 4 and to a side wall of the growth container 4.

Next, as described in FIG. 3(b), sintering is performed at a high temperature to form a TaC film from what adheres, followed by cooling. Thereby, the tantalum carbide coating film 10 is formed on the surface of the solid silicon carbide raw material 3, and a tantalum carbide coating film 10' is also formed on the side wall of the growth container 4 (see FIG. 4).

Next, as described in FIG. 3(c), the seed substrate (seed wafer) 2 is set at the upper portion of the growth container 4.

Next, as described in FIG. 3(d), the growth container 4 is disposed in the heat-insulating container 5.

Next, as described in FIG. 3(e), the heat-insulating container 5 as a whole is disposed in the external container 9.

Next, as described in FIG. 3(f), the inside of the external container 9 is made vacuum, and the temperature is raised while a predetermined pressure is being kept. Here, the inside of the external container 9 may be an argon atmosphere, nitrogen atmosphere, or the like. Preferably, in this event, the temperature is 2000°C or more, and the pressure is 100 Torr (133 hPa) or less.

Next, as described in FIG. 3(g), the SiC single crystal (grown crystal) 2a is grown by the sublimation method.

Finally, as described in FIG. 3(h), the reduced pressure is increased to stop the sublimation and the growth, and the temperature is gradually lowered for cooling.

According to the manufacturing method as described above, a silicon carbide single crystal is grown after the tantalum carbide (TaC) coating film is formed on the surface of the solid silicon carbide raw material and on the inner wall of the growth container. This makes it possible to prevent a carbon mass from floating from the solid raw material, and to prevent a reaction between the raw-material gas and the carbon of the growth container and consequently incorporation of the carbon as inclusion in the growing single crystal. Thus, more effective reduction of carbon inclusion is achieved in the grown silicon carbide crystal.

Note that, in this second embodiment, the TaC coating film is formed on the inner wall of the growth container, too. Nevertheless, as long as the TaC coating film is formed on the surface of the solid silicon carbide raw material, it is not always necessary to form the coating film on the surface of the formation container. It should be noted however that carbon inclusion can be further suppressed by growing on the inner wall of the growth container.

### EXAMPLE

Hereinafter, the present invention will be more specifically described by showing Examples and Comparative Example. However, the present invention is not limited thereto.

### (Example 1)

Under the following growth conditions, a SiC single crystal with a diameter of 4 inches (100 mm) was grown.

### <Conditions>

Seed crystal substrate... a SiC single crystal substrate with a diameter of 4 inches (100 mm) and the main surface being tilted by 4° from the {0001} plane in the <1120> direction
Growth temperature... 2200°C
Pressure... 10 Torr (13 hPa)
Atmosphere... argon and nitrogen gases

The SiC single crystal was prepared according to the procedure as described in FIG. 1 (i.e., the procedure described in the first embodiment).

The prepared single crystal was sliced. The distribution and average number (density) of carbon inclusions in the wafer plane were examined with a microscope. FIG. 5 shows the result. As can be seen from FIG. 5, the carbon inclusion density in Example 1 was 2.4/cm². This shows that significant improvement was achieved in terms of carbon inclusion in comparison with Comparative Example to be described later.

### (Example 2)

Under the following growth conditions, a SiC single crystal with a diameter of 4 inches (100 mm) was grown.

### <Conditions>

Seed crystal substrate... a SiC single crystal substrate with a diameter of 4 inches (100 mm) and the main surface being tilted by 4° from the {0001} plane in the <1120> direction
Growth temperature... 2200°C
Pressure... 10 Torr (13 hPa)
Atmosphere... argon and nitrogen gases

The SiC single crystal was prepared according to the procedure as described in FIG. 3 (i.e., the procedure described in the second embodiment).

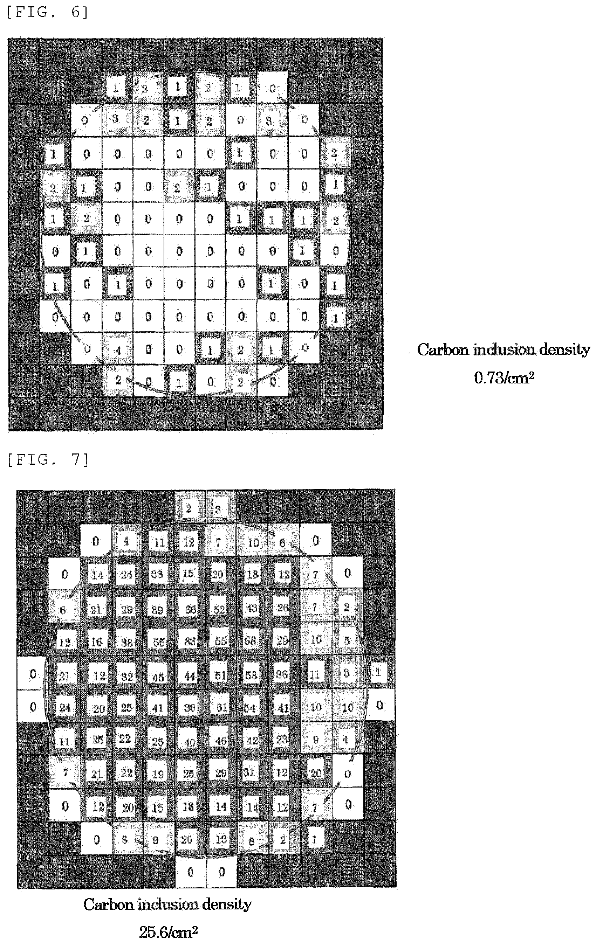

The prepared single crystal was sliced. The distribution and average number (density) of carbon inclusions in the wafer plane were examined with a microscope. FIG. 6 shows the result. As can be seen from FIG. 6, the carbon inclusion density in Example 2 was 0.73/cm². This shows that significant improvement was achieved in terms of carbon inclusion in comparison with Comparative Example to be described later. Moreover, it is shown that further improvement was achieved in Example 2 than in Example 1 in terms of carbon inclusion.

### (Comparative Example)

Under the following growth conditions, a SiC single crystal with a diameter of 4 inches (100 mm) was grown.

### <Conditions>

Seed crystal substrate... a SiC single crystal substrate with a diameter of 4 inches (100 mm) and the main surface being tilted by 4° from the {0001} plane in the <1120> direction
Growth temperature... 2200°C
Pressure... 10 Torr (13 hPa)
Atmosphere... argon and nitrogen gases

The SiC single crystal was prepared according to the procedure as described in FIG. 8.

The prepared single crystal was sliced. The distribution and average number (density) of carbon inclusions in the wafer plane were examined with a microscope. FIG. 7 shows the result. As can be seen from FIG. 7, the carbon inclusion density in Comparative Example was 25.6/cm². This shows that quite many carbon inclusions were formed in comparison with Examples 1, 2.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for manufacturing a silicon carbide single crystal by sublimating a solid silicon carbide raw material in a growth container to grow a silicon carbide single crystal on a seed crystal substrate, the method comprising:
mixing a tantalum (Ta) powder with a carbon powder;
attaching the mixture to the solid silicon carbide raw material in the growth container; and
heating the resultant for sintering to form a tantalum carbide (TaC) coating film on a surface of the solid silicon carbide raw material, wherein
a silicon carbide single crystal is grown after or while the coating film is formed.

2. The method for manufacturing a silicon carbide single crystal according to claim 1, wherein
the growth container is made of carbon, and
a mixture of a tantalum (Ta) powder and a carbon powder is further attached to an inner wall of the growth container.
